# EUROPEAN PATENT APPLICATION

(11) **EP 1 619 269 A2**
(43) Date of publication of application: **25.01.2006**
(21) Application number: 05016010.0
(22) Date of filing: 22.07.2005
(51) Int. Cl.: C23C 16/44, H01J 37/32

(54) **Method for enhancing fluorine utilization**

(30) Priority: 23.07.2004 US 897811
(71) Applicant: AIR PRODUCTS AND CHEMICALS, INC., Allentown, PA 18195-1501 (US)
(72) Inventor: Wu, Dingjun, Macungie PA 18062 (US); Ji, Bing, Allentown PA 18104 (US); Karwacki, Eugene Joseph, Jr., Orefield PA 18069 (US)
(74) Representative: Kador & Partner

(57) **Abstract**

A process for enhancing the fluorine utilization of a process gas that is used in the removal of an undesired substance from a substrate is disclosed herein. In one embodiment, there is provided a process for enhancing the fluorine utilization of a process gas comprising a fluorine source comprising: adding a hydrogen source to the process gas in an amount sufficient to provide a molar ratio ranging from about 0.01 to about 0.99 of hydrogen source to fluorine source.

## Description

### BACKGROUND OF THE INVENTION

Chemical vapor deposition (CVD) and atomic layer deposition (ALD) techniques have been used to form non-volatile solid films on a variety of substrates, including for example, silicon wafers used for semiconductor devices. Further examples of deposition techniques include atmospheric pressure chemical vapor deposition (APCVD), plasma enhanced chemical vapor deposition (PECVD), low pressure chemical vapor deposition (LPCVD), physical vapor deposition (PVD), metal-organic chemical vapor deposition (MOCVD), atomic layer chemical vapor deposition (ALCVD), physical vapor deposition (PVD), sputter coating, and epitaxial deposition. These deposition techniques typically involve introducing a vapor phase mixture of chemical reagents or precursors into a process chamber, which react under certain conditions (i.e., temperature, pressure, atmosphere, etc.) on the surface of the article to form a thin film or coating.

One drawback associated with using these deposition techniques is the undesirable deposition or accumulation of undesirable substances on the surfaces of the process chamber and fixtures contained therein. In PECVD processes, for example, not only does the substrate receive a coating of the desired material, but also the plasma reacts with and causes material to adhere to other surfaces within the process chamber. Similarly, the plasma etch techniques used in the art also result in the deposition of the etched materials and by-products from a gas discharge on the surfaces and fixtures contained within the chamber. Periodic removal of these substances is required to avoid particle formation and to maintain stable chamber operation. The composition of these substances, or deposition and/or etching residue, may vary depending upon the film deposited and/or etched within the process chamber but may typically include, for example, Si, SiO₂, silicon nitride (Si₃N₄), SiOₓN_{y}H_{z}, or other dielectrics, organosilicon materials, organosilicate composite materials, transition metals such as W and Ta, transition metal binary compounds such as WNₓ and TaNₓ, polymeric material, and transition metal ternary compounds such as WNₓC_{y}. Many of these substances tend to chemically stable, and after repeated deposition and/or etching cycles, become difficult to remove.

Since these substances could also be accumulated undesirably on the chamber walls during an etching and deposition process, process chambers need to be cleaned periodically. The processing chambers have typically cleaned by mechanical means such as scrubbing or blasting. Wet cleaning may also be used for chamber cleaning in addition to or in place of mechanical means. The aforementioned methods are undesirable for a variety of reasons, including but not limited to, increased process chamber down time, required handling of highly corrosive or poisonous chemicals, and increased wear on the process chamber through repeated assembly and disassembly.

Dry chamber cleaning methods are an attractive alternative to mechanical and/or wet cleaning techniques because it offers the follow advantages: preserves process chamber vacuum, minimizes process chamber downtime, and/or increases productivity. During a typical dry chamber cleaning process, reactive species are generated from a precursor using one or more activation means such as in-situ plasma, remote plasma, thermal heating, and ultra-violet (UV) treatment. The reactive species react with the deposition and/or etching residues within the process chamber and form volatile species. Under a vacuum condition, the volatile species are removed from the chamber and as a result the chamber is cleaned. The majority of deposition materials or etching residues can be volatized by reacting with molecular or atomic fluorine. The most direct source of fluorine atoms or molecules is fluorine (F₂) gas itself. However, F₂ by itself is dangerous and difficult to handle. Thus it is preferred, in practice, to use fluorine-containing compounds such as NF₃, SF₆, or a mixture of for example, a perfluorocarbon such as CₓF_{y} and O₂. To produce the requisite fluorine atoms or molecules from these fluorine-containing compounds, an activation step such as plasma, heating, or UV treatment is needed.

Fluorine-containing gases are effective on removing the deposition or etching residues. But the fluorine utilization of these fluorine-containing gases is sometimes low, particularly for remote plasma downstream chemical cleaning. The term "fluorine utilization" as defined herein describes the percentage of fluorine used to form volatile species by reacting with the materials to be cleaned.

### BRIEF SUMMARY OF THE INVENTION

A method that improves the fluorine utilization of a cleaning gas, thereby increasing the removal rate of a substance such as deposition and/or etching residues, is described herein. In one embodiment, there is provided a process for enhancing the fluorine utilization of a process gas comprising a fluorine source comprising: adding a hydrogen source to the process gas in an amount sufficient to provide a molar ratio ranging from about 0.01 to about 0.99 of hydrogen source to fluorine source.

In another aspect, there is provided a process for removing a substance from a surface of a process chamber that is at least partially coated with the substance comprising: providing a process gas comprising at least one reactant selected from the group comprising a hydrogen source and a fluorine source wherein the molar ratio of hydrogen-source to fluorine source ranges from about 0.01 to about 0.99; activating the process gas using at least one energy source to form reactive species; contacting the substance with the reactive species to form at least one volatile product; and removing the at least one volatile product from the process chamber.

In a further aspect, there is provided a process for removing a substance from a surface of a process chamber that is at least partially coated with the substance comprising: providing a process gas comprising at least one reactant selected from the group comprising a hydrogen source and a fluorine source wherein the molar ratio of hydrogen source to fluorine source ranges from about 0.01 to about 0.99; activating the process gas using at least one energy source to form reactive species wherein at least a portion of the activating step is conducted outside of the process chamber; contacting the substance with the reactive species to form at least one volatile product; and removing the at least one volatile product from the process chamber.

In another aspect, there is provided a process for enhancing the fluorine utilization of a process gas comprising nitrogen trifluoride comprising: adding hydrogen to the process gas in an amount sufficient to provide a molar ratio ranging from about 0.1 to about 0.3 of hydrogen to nitrogen trifluoride.

### BRIEF DESCRIPTION OF SEVERAL VIEWS OF THE DRAWINGS

Figure 1 is a schematic diagram of an experimental system used in the Examples.

Figure 2 is graph of the H₂/NF₃ ratio versus SiO₂ etch rate in nanometers/minutes (nm/min) for remote plasma etching of SiO₂ materials.

Figure 3a provides a FTIR spectrum of an exhaust gas stream from a comparative process that did not use a hydrogen source in its process gas.

Figure 3b provides a FTIR spectrum of an exhaust gas stream from a process disclosed herein wherein the process gas contains a hydrogen source.

### DETAILED DESCRIPTION OF THE INVENTION

A method that improves the fluorine utilization of a cleaning gas, thereby increasing the removal rate of a substance such as deposition and/or etching residues, is described herein. A fluorine source such as nitrogen trifluoride (NF₃) is commonly used for chamber cleaning in electronics and glass industries. Currently, its fluorine utilization is relatively low. An increase of its fluorine utilization would be highly desirable. For embodiments employing NF₃ or other fluorine sources in the cleaning chemistry, a higher fluorine utilization rate would reduce the equipment cost of ownership (CoO).

The process described herein improves the fluorine utilization of a fluorine source such as NF₃ by adding a certain amount of a hydrogen source to the process gas. It is surprising and unexpected that the combination of a hydrogen source and a fluorine source in a molar ratio that ranges from about 0.01 to about 0.99 or from about 0.01 to 0.6 of from about 0.1 to about 0.3 may increase the etching/removal rate of a variety of substances including Si, SiO₂, WNₓC_{y}, polymeric compounds, organosilicate composites, and/or halide compounds. This proposition is contrary to conventional wisdom in fluorine-based etch/cleaning chemistries. The conventional wisdom suggests that the addition of a hydrogen source into a fluorine-containing plasma may lead to formation of HF which can result in the decrease of reactive fluorine atoms thereby reducing the effectiveness of the etch/clean processes.

The process disclosed herein is useful for cleaning a variety of substances from at least a portion of a surface within a process chamber. Non-limiting examples of substances to be removed include Si, SiO₂, silicon nitride (Si₃N₄), SiOₓN_{y}H_{z}, or other dielectrics, organosilicon materials, organosilicate composite materials, transition metals such as W and Ta, polymeric materials, transition metal binary compounds such as WNₓ and TaNₓ, and transition metal ternary compounds such as WNₓC_{y}. The substances may be removed from one or more surfaces within the process chamber and any fixtures contained therein by contacting it with reactive species under conditions sufficient to react with the substance and form volatile products. The term "volatile products", as used herein, relates to reaction products and by-products of the reaction between the substances within the process chamber and reactive species formed by activating a process gas comprising a hydrogen source and a fluorine source.

The process disclosed herein is useful for cleaning various substances from the inside of process chambers and the surfaces of various fixtures contained therein such as, but not limited to, fluid inlets and outlets, showerheads, work piece platforms, etc while minimizing damage thereto. Exemplary process chambers include chemical vapor deposition (CVD) reactors, metal-organic chemical vapor deposition (MOCVD) reactors, atomic layer deposition (ALD) reactors, atomic layer chemical vapor deposition (ALCVD) reactors, physical vapor deposition (PVD) reactors, and sputter coating reactors. The surface of the chamber and fixtures contained therein may be comprised of a variety of different materials including metals, such as titanium, aluminum, stainless steel, nickel, or alloys comprising same, and/or insulating materials, such as a ceramic, e.g., quartz or Al₂O₃.

The process gas comprises a hydrogen source, a fluorine source, and optionally at least one inert diluent gas. The molar ratio of the hydrogen source to the fluorine sourceranges from about 0.01 to about 0.99 or from about 0.1 to about 0.6 or from about 0.1 to about 0.3. It is understood that the molar ratio may vary depending on the selection of hydrogen and fluorine sources within the process gas. In one particular embodiment such as when the process gas comprises H₂ and NF₃ as the hydrogen and fluorine sources, respectively, the preferred molar ratio of hydrogen source to fluorine source may range from about 0.1 to about 0.3. However, in other embodiments, such as when the process gas contains H₂ and F₂ the molar ratio may be broader such as ranging from about 0.01 to about 0.99. Examples of hydrogen sources that may be used include hydrogen (H₂), ammonia (NH₃), methane (CH₄), trifluoromethane (CHF₃), fluoromethane (CH₃F), CH₂F₂, and mixtures thereof. The amount of hydrogen source present in the process gas may range from 0.1 % to 99.9% or from 0.1 to 50% or from 0.1 to 40% by volume based upon the total volume or process gas.

The process gas comprises a fluorine source. Examples of fluorine sources suitable for the process described herein include: HF (hydrofluoric acid), NF₃ (nitrogen trifluoride), SF₆ (sulfur hexafluoride), FNO (nitrosyl fluoride), C₃F₃N₃ (cyanuric fluoride), C₂F₂O₂ (oxalyl fluoride), perfluorocarbons such as CF₄, C₂F₆, C₃F₈, C₄F₈ etc., hydrofluorocarbons such as CHF₃ and C₃F₇H etc., a hydrofluoroether (e.g., CF₃-O-CH₃ (methyl trifluoromethyl ether)), oxyfluorocarbons such as C₄F₈O (perfluorotetrahydrofuran) etc., oxygenated hydrofluorocarbons such as CH₃OCF₃ (HFE-143a), hypofluorites such as CF₃-OF (fluoroxytrifluoromethane (FTM)) and FO-CF₂-OF (bis-difluoroxy-difluoromethane (BDM)), etc., fluoroperoxides such as CF₃-O-O-CF₃ (bis-trifluoro-methyl-peroxide (BTMP)), F-O-O-F etc., fluorotrioxides such as CF₃-O-O-O-CF₃ etc., fluoroamines such a CF₅N (perfluoromethylamine), fluoronitriles such as C₂F₃N (perfluoroacetonitrile), C₃F₆N (perfluoroproprionitrile), and CF₃NO (trifluoronitrosylmethane), and COF₂ (carbonyl fluoride). The fluorine source can be delivered by a variety of means, such as, but not limited to, conventional cylinders, safe delivery systems, vacuum delivery systems, and/or solid or liquid-based generators that create the fluorine source at the point of use. The amount of fluorine source present within the process gas can range from 0.1 % to 99.9% or from 25% to 99% by volume based upon the total volume of process gas.

In certain embodiments, one or more inert diluent gases may be added to the process gas. Examples of inert diluent gases include nitrogen, CO₂, helium, neon, argon, krypton, and xenon. The amount of inert diluent gas that may be present within the process gas can range from 0% to 99.9% by volume based upon total volume of process gas.

In certain preferred embodiments, the process gas is substantially free of oxygen or an oxygen source. Examples of oxygen sources include oxygen (O₂), ozone (O₃), carbon monoxide (CO), carbon dioxide (CO₂), nitrogen dioxide (NO₂), nitrous oxide (N₂O), nitric oxide (NO), water (H₂O), and mixtures thereof.

The process gas may be activated by one or more energy sources such as, but not limited to, in situ plasma, remote plasma, remote thermal/catalytic activation, in-situ thermal heating, electron attachment, and photo activation to form reactive species. These sources may be used alone or in combination.

Thermal or plasma activation and/or enhancement can significantly impact the efficacy of the etching and cleaning of certain substances. In thermal heating activation, the process chamber and fixtures contained therein are heated either by resistive heaters or by intense lamps. The process gas is thermally decomposed into reactive radicals and atoms that subsequently volatize the substance to be removed. Elevated temperature may also provide the energy source to overcome reaction activation energy barrier and enhance the reaction rates. For thermal activation, the substrate can be heated to at least 100°C, or at least 300°C, or at least 500 °C. The pressure range is generally 10 mTorr to 760 Torr, or 1 Torr to 760 Torr.

In embodiments wherein an in situ activation source such as in situ plasma is used to activate the process gas, hydrogen and fluorine gas molecules contained within the process gas may be broken down by the discharge to form reactive species such as reactive ions and radicals. The fluorine-containing ions and radicals can react with the undesired substances to form volatile species that can be removed from the process chamber by vacuum pumps. For in situ plasma activation, one can generate the plasma with a 13.56 MHz RF power supply, with RF power density at least 0.2 W/cm², or at least 0.5 W/cm², or at least 1 W/cm². One can also operate the in situ plasma at RF frequencies lower than 13.56 MHz to enhance cleaning of grounded chamber walls and/or fixtures contained therein. The operating pressure is generally in the range of 2.5 mTorr to 100 Torr, or 5 mTorr to 50 Torr, or 10 mTorr to 20 Torr. Optionally, one can also combine thermal and plasma enhancement.

In certain embodiments, a remote activation source, such as, but not limited to, a remote plasma source, a remote thermal activation source, a remote catalytically activated source, or a source which combines thermal and catalytic activation, is used in addition to an in situ plasma to generate the volatile product. In remote plasma cleaning, the process gas is activated to form reactive species outside of the deposition chamber which are introduced into the process chamber to volatize the undesired substance. Either an RF or a microwave source can generate the remote plasma source. In addition, reactions between remote plasma generated reactive species and the substance to be removed can be activated/enhanced by heating the reactor. The reaction between the remote plasma generated reactive species and substance to be removed can be activated and/or enhanced by heating the reactor to a temperature sufficient to dissociate the hydrogen and fluorine containing sources contained within the process gas. The specific temperature required to activate the cleaning reaction with the substance to be removed depends on the process gas recipe.

Altematively, the cleaning molecules can be dissociated by intense ultraviolet (UV) radiation to form reactive radicals and atoms. UV radiation can also assist breaking the strong chemical bonds in the unwanted materials; hence increase the removal rates of the substance to be removed.

In remote thermal activation, the process gas first flows through a heated area outside of the process chamber. Here, the gas dissociates by contact with the high temperatures within a vessel outside of the chamber to be cleaned. Alternative approaches include the use of a catalytic converter to dissociate the process gas, or a combination of thermal heating and catalytic cracking to facilitate activation of the hydrogen and fluorine sources within the process gas.

In alternative embodiments, the molecules of the hydrogen and fluorine sources within the process gas can be dissociated by intense exposure to photons to form reactive species. For example ultraviolet, deep ultraviolet and vacuum ultraviolet radiation can assist breaking strong chemical bonds in the substance to be removed as well as dissociating the hydrogen and fluorine sources within the process gas thereby increasing the removal rates of the undesired substance.

Other means of activation and enhancement to the cleaning processes can also be employed. For example, one can use photon induced chemical reactions, either remotely or *in situ,* to generate reactive species and enhance the etching/cleaning reactions. One can also use catalytic conversion of cleaning gases to form reactive species for cleaning the process chambers.

The process described herein will be illustrated in more detail with reference to the following Examples, but it should be understood that the process is not deemed to be limited thereto.

### EXAMPLES

The following are experimental examples showing how the addition of a hydrogen source to a fluorine source in a particular molar ratio enhances the etch rates of a variety of substances including Si, SiO₂, and WNₓC_{y}.

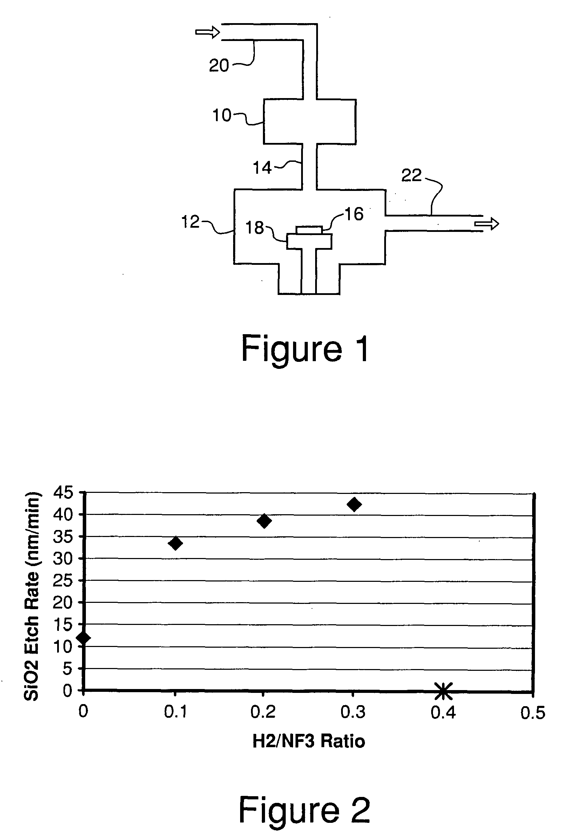

Figure 1 is a schematic diagram of the experimental setup. A remote plasma generator from MKS (Model Astron AX7561) was directly mounted on top of a reactor chamber. The distance between the exit of the Astron and the test sample is about six inches. Figure 1 shows the schematic diagram of the experimental setup. Remote plasma generator 10 (an MKS ASTRON, available from MKS Instruments of Wilmington, MA) was mounted on top of reactor 12. The distance between exit 14 of plasma generator 10 and test sample 16 was approximately six inches (15.25 cm). Sample 16 was placed on a surface of pedestal heater 18. The heater was used to obtain different substrate temperatures. Process gases were fed to plasma generator 10 via pipe 20. In all of the runs, the chamber pressure was kept at 4 torr with the assistance of pump port 22.

For each experimental run, a test sample was put onto a support plate inside the process chamber. The chamber was then evacuated. Process gases were fed into the chamber and chamber pressure was stabilized. The reactive gases were then activated by a remote plasma. The detailed experimental sequence was listed as follows:
1. Vent chamber and open front door;
2. Load a test sample and close front door;
3. Evacuate chamber to reach baseline vacuum pressure;
4. Introduce argon (Ar) and stabilize pressure;
5. Turn on the remote plasma power;
6. Introduce process gases;
7. Turn off the remote plasma power after a preset time;
8. Stop process flows and evacuate chamber;
9. Vent chamber and retrieve the test sample for analysis.

For WNₓC_{y} and SiO₂, the etch rate was determined by the sample's thickness difference before and after the remote plasma treatment. The thickness of WNₓC_{y} was measured by profilometer while the thickness of SiO₂ was measured by reflectometer. For Si, the etch rate was determined by the sample's weight change before and after the remote plasma treatment. A 1" square piece of WNₓC_{y}, a 4" blank Si wafer, and a 4" silicon wafer coated with 1 micrometer SiO₂ film were used as the test samples.

### Example 1: Remote plasma cleaning of silicon (Si) materials

An experiment illustrating the effect of a remote plasma activated process gas with and without the addition of a hydrogen source is illustrated herein using a silica (Si) test sample (i.e., a 4" blank Si wafer). The experimental setup is the same as that described above. Table 1 lists the experimental results when Si was used as the substance. A balance was used to check the weight change of the Si test samples before and after the remote plasma treatment. The Si removal rate is defined as the Si weight loss per unit time of remote plasma treatment. Table I shows that the Si removal was significantly increased, or 125 % higher, with the addition of H₂ addition.

**Table 1. Remote plasma etching of Si materials**

| Run# | NF₃ flow (sccm) | Ar flow (sccm) | H₂ flow (sccm) | H₂ / NF₃ mole ratio | Si removal rate (mg/min) |
|---|---|---|---|---|---|
| Comparative (Comp.) Example (Ex.) 1 | 50 | 50 | 0 | 0 | 8 |
| Ex. 1 | 50 | 50 | 10 | 0.2 | 18 |

### Example 2. Remote plasma cleaning of silicon dioxide (SiO₂) materials

The experimental setup is the same as that described above. Figure 2 provides a graphical illustration of the effect of the H₂/NF₃ molar ratio on SiO₂ etch rate. At a condition of 50 sccm Ar, 50 sccm NF₃, and 4 torr chamber pressure, the SiO₂ etch rate increased with the increase of the H₂/NF₃ ratio. Figure 2 further shows that the increase in etch rate was less significant at higher H₂/NF₃ ratios. When the H₂/NF₃ mole ratio reached 0.4, the remote plasma was distinguished. As a result, there was no etching at a H₂/NF₃ ratio of 0.4.

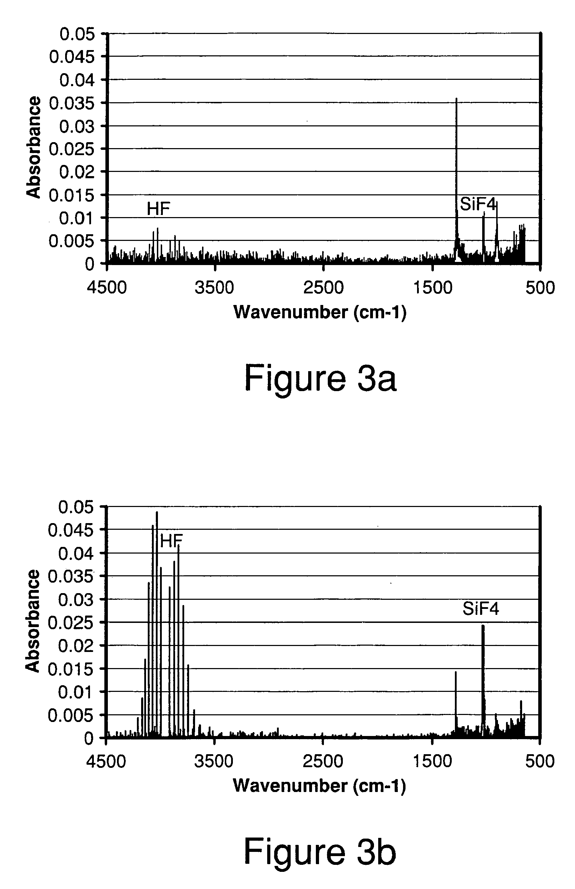

Figures 3a and 3b provide the FTIR spectrum of the exhaust gas streams taken during the SiO₂ etching processes without and with H₂ addition, respectively. A comparison of Figures 3a and 3b shows that the H₂ addition generates HF and increases the SiF₄ absorbance intensity. One possible reaction pathway for HF generation is H + F₂ → HF + F·. In this connection, it is believed that the NF₃ utilization may be increased because more F· radicals are generated through the reaction between the H· radical and the recombined F₂ molecule. The increase of SiF₄ absorbance intensity of Figure 3b compared to Figure 3a further confirms the increase of SiO₂ etch rate and NF₃ utilization with H₂ addition.

Table 2 provides various experimental results of SiO₂ etching at three different NF₃ flow rates, 50 sccm, 100 sccm, and 150 sccm and with and without the addition of H₂. The results in Table 2 confirm that the effect of H₂ addition on SiO₂ etching was more significant at a lower flow ranges.

**Table 2. Remote plasma etching of SiO₂ materials**

| Run# | NF₃ flow (sccm) | Ar flow (sccm) | H₂ flow (sccm) | SiO₂ etch rate (nm/min) |
|---|---|---|---|---|
| Comp. Ex. 2a | 50 | 50 | 0 | 14 |
| Ex. 2a | 50 | 50 | 8.5 | 25 |
| Comp. Ex. 2b | 100 | 100 | 0 | 23 |
| Ex. 2b | 100 | 100 | 15 | 39 |
| Comp. Ex. 2c | 150 | 150 | 0 | 50 |
| Ex. 2c | 150 | 150 | 22.5 | 62 |

To confirm the unique interactions between NF₃ and H₂, three other gases, Ar, He, and O₂, were each tested for its effect on SiO₂ etching as an additive gas to NF₃. Table 3 lists the SiO₂ etch rate changes using the different additive gases. Under the same NF₃ flow rate (100 sccm), chamber pressure (4 torr), and the molar ratio of additive gas to NF₃, H₂ was found to be the only additive gas that significantly increased the SiO₂ etch rate. By contrast, the addition of O₂ at an O₂/NF₃ ratio of 0.15 decreased the SiO₂ etch rate by half. The results of Table 3 indicate that addition of H₂ enhances the etching rate.

**Table 3. Comparison of SiO₂ Etch Rates under Different Additive Gases**

| Additive gas | NF₃ flow (sccm) | Ar flow (sccm) | Additive gas flow (sccm) | Molar ratio of additive gas to NF₃ | SiO₂ etch rate change over base case |
|---|---|---|---|---|---|
| Comp. Ex. 2d (None) | 100 | 100 | 0 | 0 | 1 |
| Ex. 2d (H₂) | 100 | 100 | 15 | 0.15 | 1.3 |
| Comp. Ex. 2e (Ar) | 100 | 100 | 15 | 0.15 | 1 |
| Comp. Ex. 2f (He) | 100 | 100 | 15 | 0.15 | 1 |
| Comp. Ex. 2g (O₂) | 100 | 100 | 20 | 0.2 | 0.6 |

### Example 3. Remote plasma cleaning of ternary tungsten nitride carbide (WNₓC_{y}) materials

At the same Ar and NF₃ flow rates (50 sccm for both Ar and NF₃), the same reactor chamber pressure (4 torr), and the same etch time (2 minutes), the H₂ flow rate was incrementally changed from 0 to 15 sccm. Table 4 lists the WNₓC_{y} etch rates at the different H₂ flow rates. With the addition of either 10 sccm H₂ or 15 sccm H₂, the entire WNₓC_{y} layer was etched away. In addition, a significant amount of Si was also etched at both conditions. Among all the test conditions, the film thickness was reduced the most at the H₂/NF₃ ratio of 0.2, which indicates that there is an optimum H₂/ NF₃ molar ratio for the etching of WNₓC_{y} materials.

**Table 4. Remote plasma etching of WNₓC_{y} materials**

| Run# | NF₃ flow (sccm) | Ar flow (sccm) | H₂ Flow Rate | H₂/NF₃ (mole ratio) | Film thickness change due to etching (nm) | WNₓC_{y} etch rate (nm/min) |
|---|---|---|---|---|---|---|
| Comp. Ex. 3 | 50 | 50 | 0 | 0 | 60 | 30 |
| Ex. 3a | 50 | 50 | 5 | 0.1 | 53 | 27 |
| Ex. 3b | 50 | 50 | 10 | 0.2 | 622 | >45 |
| Ex. 3c | 50 | 50 | 15 | 0.3 | 378 | >45 |

## Claims

1. A process for enhancing the fluorine utilization of a process gas comprising a fluorine source comprising: adding a hydrogen source to the process gas in an amount sufficient to provide a molar ratio ranging from about 0.01 to about 0.99 of hydrogen source to fluorine source.

2. A process for removing a substance from a surface of a process chamber that is at least partially coated with the substance, said process comprising:
providing a process gas comprising at least one reactant selected from the group comprising a hydrogen source and a fluorine source wherein the molar ratio of hydrogen source to fluorine source ranges from about 0.01 to about 0.99;
activating the process gas using at least one energy source to form reactive species;
contacting the substance with the reactive species to form at least one volatile product; and removing the at least one volatile product from the process chamber.

3. The process of claim 2 wherein the fluorine source comprises at least one selected from F₂; HF, NF₃; SF₆; COF₂; NOF; C₃F₃N₃; C₂F₂O₂; a perfluorocarbon; a hydrofluorocarbon; an oxyfluorocarbon; an oxygenated hydrofluorocarbon; a hypofluorite; a hydrofluoroether; a fluoroperoxide; a fluorotrioxide; a fluoroamine; a fluoronitrile; and mixtures thereof.

4. The process of claim 2 wherein the hydrogen source comprises at least one selected from H₂; NH₃; CH₄; CHF₃; CH₂F₂; CH₃F; and mixtures thereof.

5. The process of claim 2 wherein the process gas further comprises at least one inert diluent gas selected from N₂, He, Ne, Kr, Xe, Ar, and mixtures thereof.

6. The process of claim 2 wherein the at least one energy source is a remote plasma source.

7. The process of claim 6 wherein the plasma is generated at a plasma pressure of 0.5 to 50 Torr.

8. The process of claim 6 wherein the plasma generator has a RF power ranging from 100 to 10,000 Watts.

9. A process for removing a substance from a surface of a process chamber that is at least partially coated with the substance, said process comprising:
providing a process gas comprising at least one reactant selected from the group comprising a hydrogen source and a fluorine source wherein the molar ratio of hydrogensource to fluorine source ranges from about 0.01 to about 0.99;
activating the process gas using at least one energy source to form reactive species wherein at least a portion of the activating step is conducted outside of the process chamber;
contacting the substance with the reactive species to form at least one volatile product; and
removing the at least one volatile product from the process chamber.

10. A process for enhancing the fluorine utilization of a process gas comprising nitrogen trifluoride comprising: adding hydrogen to the process gas in an amount sufficient to provide a molar ratio ranging from about 0.1 to about 0.3 of hydrogen to nitrogen trifluoride.
